# EUROPEAN PATENT APPLICATION

(11) **EP 4 576 139 A1**
(43) Date of publication of application: **25.06.2025**
(21) Application number: 23867879.1
(22) Date of filing: 19.07.2023
(51) Int. Cl.: H01G 4/30

(54) **MULTILAYER CERAMIC ELECTRONIC COMPONENT**

(30) Priority: 21.09.2022 JP 2022150525
(71) Applicant: Murata Manufacturing Co., Ltd., Nagaokakyo-shi, Kyoto 617-8555 (JP)
(72) Inventor: MISHIMA, Yasuhiro, Nagaokakyo-shi, Kyoto 617-8555 (JP)
(74) Representative: Stöckeler, Ferdinand
(86) International application number: PCT/JP2023/026360
(87) International publication number: WO 2024/062753

(57) **Abstract**

Provided are multilayer ceramic electronic components that are each able to reduce ESR. A multilayer ceramic capacitor 1 includes a first external electrode 40A and a second external electrode 40B. The first external electrode 40A includes a first base electrode layer 50A, a first electrically conductive resin layer 60A that is provided on the first base electrode layer 50A and includes a thermosetting resin and a metal component, and a first Ni plated layer 71A provided on the first electrically conductive resin layer 60A. The second external electrode 40B includes a second base electrode layer 50B, a second electrically conductive resin layer 60B that is provided on the second base electrode layer 50B and includes a thermosetting resin and a metal component, and a second Ni plated layer 71B provided on the second electrically conductive resin layer 60B. Tensile stress remains as internal stress inside the first Ni plated layer 71A and inside the second Ni plated layer 71B.

## Description

### TECHNICAL FIELD

The present invention relates to a multilayer ceramic electronic component.

### BACKGROUND ART

In recent years, multilayer ceramic electronic components such as multilayer ceramic capacitors are required to be durable under severe environments such as bending stress due to thermal expansion, and a technique is known which adopts a thermosetting electrically conductive resin paste for external electrodes on the multilayer ceramic electronic components. Patent Document 1 discloses this type of technology. Patent Document 1 discloses a multilayer ceramic capacitor including external electrodes, each including a layer structure in which an electrode layer prepared by dipping an electrically conductive paste and firing the resulting electrode layer, an electrically conductive epoxy thermosetting resin layer, a nickel plated layer, and a tin-based layer are sequentially laminated.

### Citation List

### Patent Document

Patent Document 1: Japanese Unexamined Patent Application, Publication No. H11-162771

### DISCLOSURE OF THE INVENTION

### Problems to be Solved by the Invention

However, various measures such as a reduction in Equivalent Series Resistance (ESR) have been taken for the multilayer ceramic electronic components in order to satisfy required performance, while maintaining durability under severe environments, and further improvement of performance is demanded.

Embodiments of the present invention provide multilayer ceramic electronic components that are each able to reduce ESR.

### Means for Solving the Problems

Embodiments of the present invention provide multilayer ceramic electronic components that each include:
a multilayer body including a plurality of laminated ceramic layers, a first main surface and a second main surface opposed to each other in a height direction, a first lateral surface and a second lateral surface opposed to each other in a width direction orthogonal or substantially orthogonal to the height direction, and a first end surface and a second end surface opposed to each other in a length direction orthogonal or substantially orthogonal to the height direction and the width direction; first internal conductive layers that are each on a corresponding one of the plurality of ceramic layers and are each exposed at the first end surface; second internal conductive layers that are each on a corresponding one of the plurality of ceramic layers and are each exposed at the second end surface; a first external electrode on the first end surface; and a second external electrode on the second end surface. The first external electrode includes a first base electrode layer including a metal component, a first electrically conductive resin layer that is provided on the first base electrode layer and includes a thermosetting resin and a metal component, and a first Ni plated layer provided on the first electrically conductive resin layer; the second external electrode includes a second base electrode layer including a metal component, a second electrically conductive resin layer that is provided on the second base electrode layer and includes a thermosetting resin and a metal component, and a second Ni plated layer provided on the second electrically conductive resin layer; tensile stress remains as internal stress inside the first Ni plated layer; and tensile stress remains as internal stress inside the second Ni plated layer.

### Effects of the Invention

According to the embodiments of the present invention, it is possible to provide multilayer ceramic electronic components that are each able to reduce ESR.

### BRIEF DESCRIPTION OF THE DRAWINGS

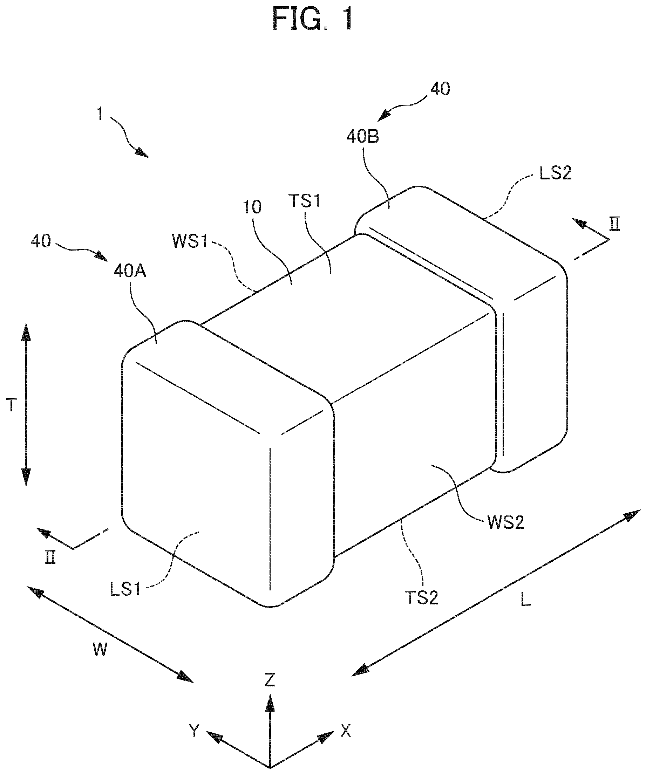

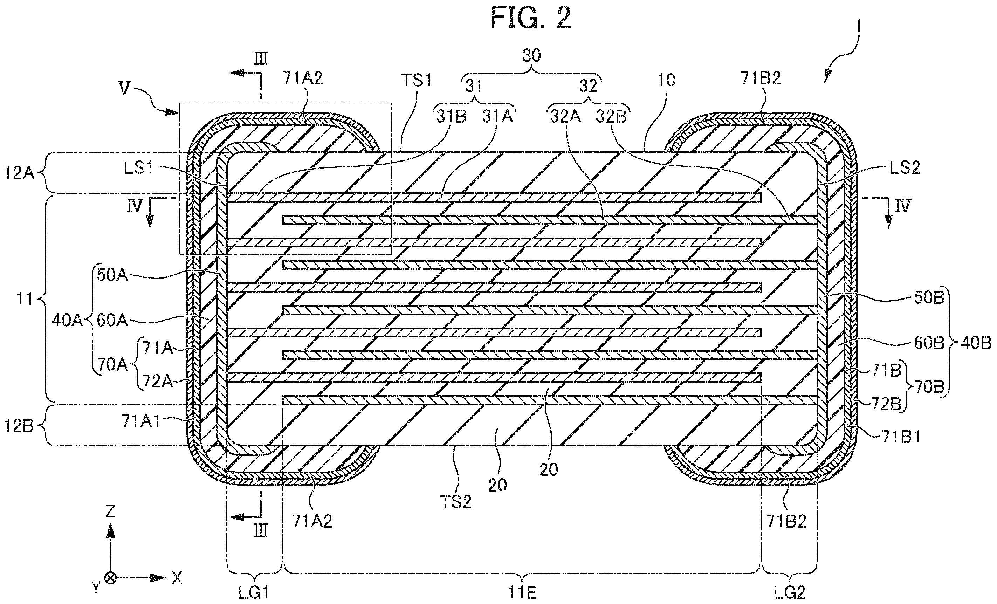

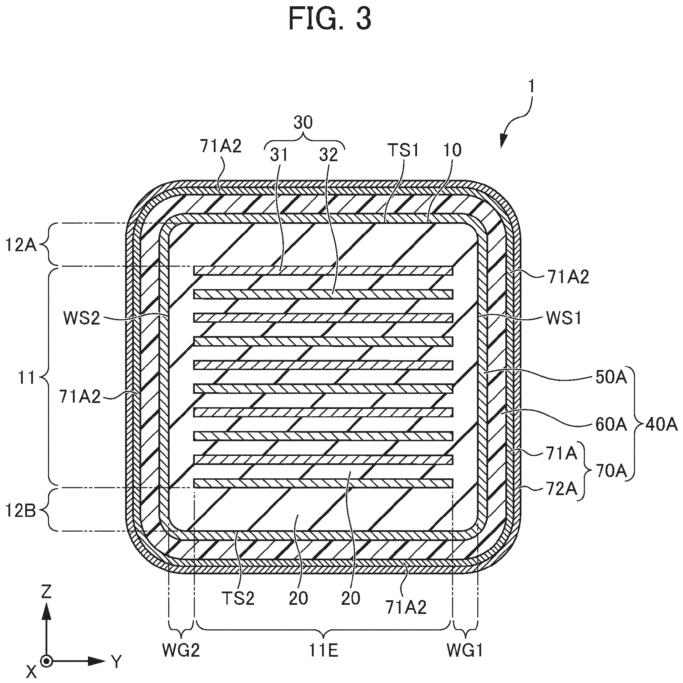

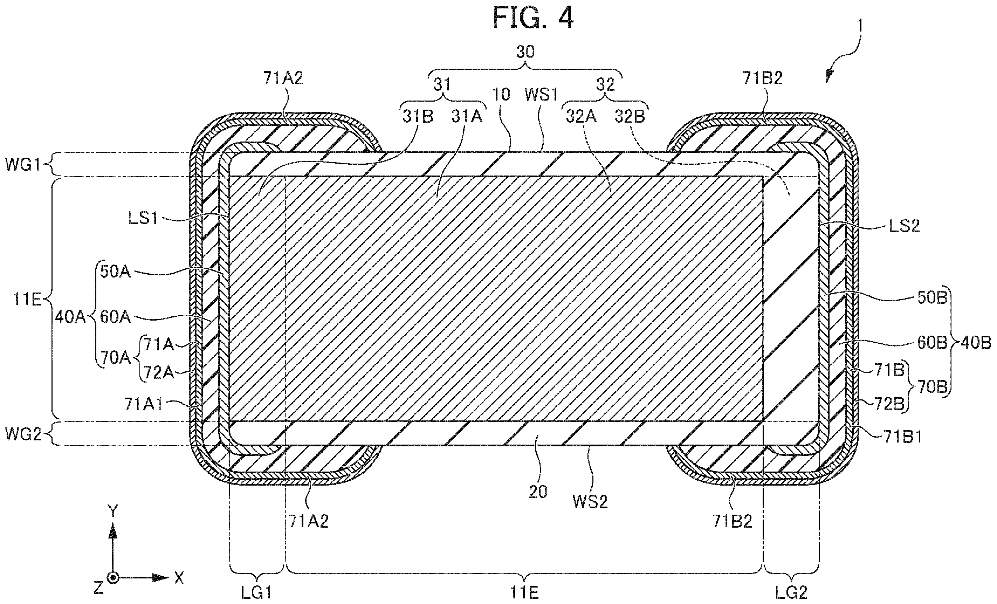

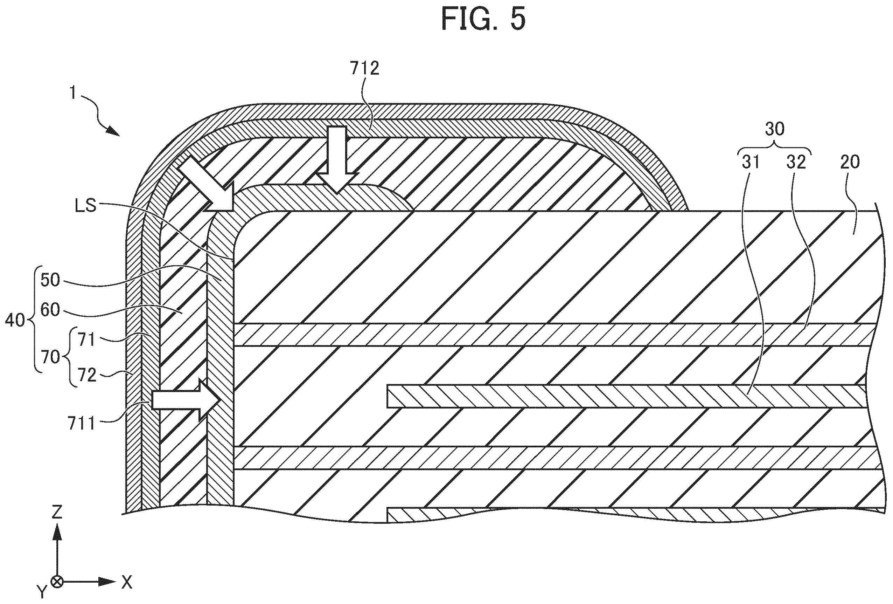

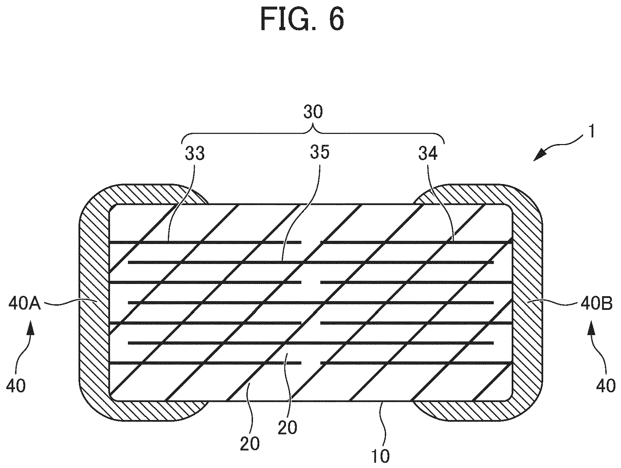

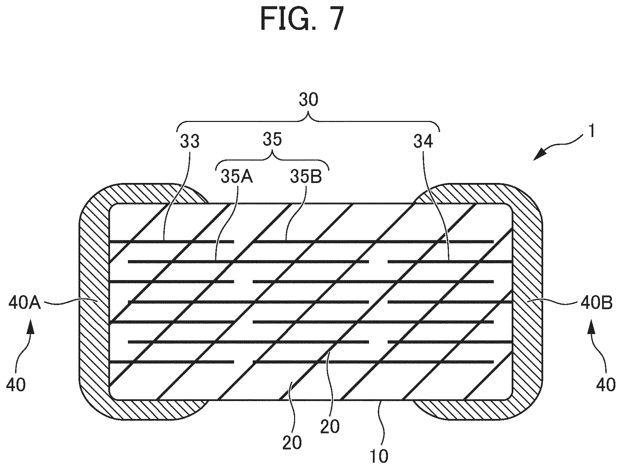

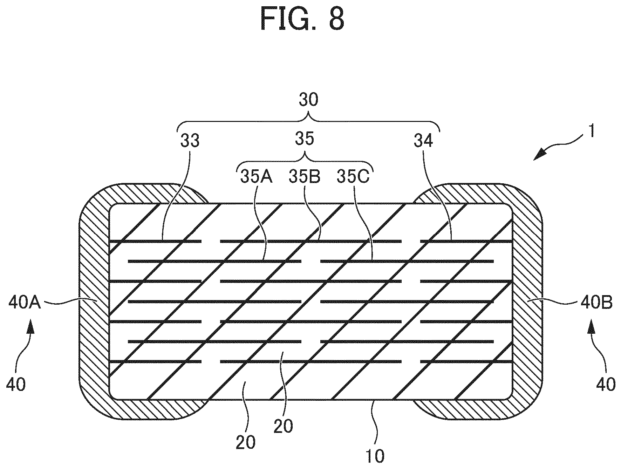

FIG. 1 is an external perspective view of a multilayer ceramic capacitor of an embodiment of the present invention. FIG. 2 is a cross-sectional view taken along the line II-II of the multilayer ceramic capacitor of FIG. 1. FIG. 3 is a cross-sectional view taken along the line III-III of the multilayer ceramic capacitor of FIG. 2. FIG. 4 is a cross-sectional view taken along the line IV-IV of the multilayer ceramic capacitor of FIG. 2. FIG. 5 is an enlarged view of a portion V of the multilayer ceramic capacitor shown in FIG. 2, and is a schematic view for explaining a state of the force generated in the vicinity of an end surface of the multilayer ceramic capacitor. FIG. 6 is a schematic view of an example of a configuration of a multilayer ceramic capacitor having a two-portion structure. FIG. 7 is a schematic view of an example of a configuration of a multilayer ceramic capacitor having a three-portion structure. FIG. 8 is a schematic view of an example of a configuration of a multilayer ceramic capacitor having a four-portion structure.

### PREFERRED MODE FOR CARRYING OUT THE INVENTION

### Embodiment

Hereinafter, a multilayer ceramic capacitor 1 functioning as a multilayer ceramic electronic component according to a first embodiment of the present invention will be described with reference to FIGS. 1 to 4. FIG. 1 is an external perspective view of a multilayer ceramic capacitor 1 of the present embodiment. FIG. 2 is a cross-sectional view of the multilayer ceramic capacitor 1 taken along the line II-II of FIG. 1. FIG. 3 is a cross-sectional view of the multilayer ceramic capacitor 1 taken along the line III-III of FIG. 2. FIG. 4 is a cross-sectional view of the multilayer ceramic capacitor 1 taken along the line IV-IV of FIG. 2.

The multilayer ceramic capacitor 1 includes a multilayer body 10 and external electrodes 40.

FIGS. 1 to 4 each show an XYZ Cartesian coordinate system. The length direction L of the multilayer ceramic capacitor 1 and the multilayer body 10 corresponds to the X direction. The width direction W of the multilayer ceramic capacitor 1 and the multilayer body 10 corresponds to the Y direction. The lamination (stacking) direction T as the height direction of the multilayer ceramic capacitor 1 and the multilayer body 10 corresponds to the Z direction. Here, the cross section shown in FIG. 2 is also referred to as an LT cross section. The cross section shown in FIG. 3 is also referred to as a WT cross section. The cross section shown in FIG. 4 is also referred to as an LW cross section.

As shown in FIGS. 1 to 4, the multilayer body 10 includes a first main surface TS1 and a second main surface TS2 which are opposed to each other in the lamination direction T, a first lateral surface WS1 and a second lateral surface WS2 which are opposed to each other in the width direction W orthogonal or substantially orthogonal to the lamination direction T, and a first end surface LS1 and a second end surface LS2 which are opposed to each other in the length direction L orthogonal or substantially orthogonal to the lamination direction T and the width direction W.

As shown in FIG. 1, the multilayer body 10 has a substantially rectangular parallelepiped shape. The dimension in the length direction L of the multilayer body 10 is not necessarily longer than the dimension in the width direction W. The corner portions and ridge portions of the multilayer body 10 are preferably rounded. Each of the corner portions is a portion where the three surfaces of the multilayer body 10 intersect, and each of the ridge portions is a portion where the two surfaces of the multilayer body 10 intersect. In addition, unevenness or the like may be provided on a portion or the entirety of the surface of the multilayer body 10.

The dimension of the multilayer body 10 is not particularly limited, but when the dimension in the length direction L of the multilayer body 10 is defined as an L dimension, the L dimension is preferably 0.2 mm or more and 10 mm or less. When the dimension of the multilayer body 10 in the lamination direction T is defined as a T dimension, the T dimension is preferably 0.1 mm or more and 10 mm or less. When the dimension of the multilayer body 10 in the width direction W is defined as a W direction, the dimension W is preferably 0.1 mm or more and 10 mm or less.

As shown in FIGS. 2 and 3, the multilayer body 10 includes an inner layer portion 11, and a first main surface-side outer layer portion 12A functioning as a first outer layer portion and a second main surface-side outer layer portion 12B functioning as a second outer layer portion sandwiching the inner layer portion 11 in the lamination direction T.

The inner layer portion 11 includes a plurality of dielectric layers 20 functioning as a plurality of ceramic layers and a plurality of internal electrode layers 30 functioning as a plurality of internal conductive layers. The inner layer portion 11 includes an internal electrode layer 30 positioned closest to the first main surface TS1 to an internal electrode layer 30 positioned closest to the second main surface TS2 in the lamination direction T. In the inner layer portion 11, the plurality of internal electrode layers 30 are opposed to each other with each of the plurality of dielectric layers 20 interposed therebetween. The inner layer portion 11 is a portion that substantially functions as a capacitor for generating capacitance.

The plurality of dielectric layers 20 are made of a dielectric material. The dielectric material may be, for example, a dielectric ceramic containing components such as BaTiO₃, CaTiO₃, SrTiO₃, or CaZrO₃. Further, the dielectric material may be a material obtained by adding subcomponents such as Mn compound, Fe compound, Cr compound, Co compound, and Ni compound to these main components.

The thickness of each of the plurality of dielectric layers 20 is preferably 0.5 µm or more and 15 µm or less. The number of laminated dielectric layers 20 is preferably 10 or more and 700 or less. The number of dielectric layers 20 is a total number of the number of dielectric layers of the inner layer portion 11 and the number of dielectric layers of the first main surface-side outer layer portion 12A and the second main surface-side outer layer portion 12B.

The plurality of internal electrode layers 30 includes first internal electrode layers 31 functioning as a plurality of first internal conductive layers and second internal electrode layers 32 functioning as a plurality of second internal conductive layers. The plurality of first internal electrode layers 31 are provided on the plurality of dielectric layers 20. The plurality of second internal electrode layers 32 are provided on the plurality of dielectric layers 20. The plurality of first internal electrode layers 31 and the plurality of second internal electrode layers 32 are alternately provided with each of the plurality of dielectric layers 20 interposed therebetween in the lamination direction T of the multilayer body 10. One of the first internal electrode layers 31 and one of the second internal electrode layers 32 sandwich one of the dielectric layers 20.

Each of the plurality of first internal electrode layers 31 includes a first counter portion 31A opposed to each of the plurality of second internal electrode layers 32, and a first extension portion 31B extending from the first counter portion 31A toward the first end surface LS1. The first extension portion 31B is exposed at the first end surface LS1.

Each of the plurality of second internal electrode layers 32 includes a second counter portion 32A opposed to each of the plurality of first internal electrode layers 31, and a second extension portion 32B extending from the second counter portion 32A toward the second end surface LS2. The second extension portion 32B is exposed at the second end surface LS2.

In the present embodiment, the first counter portion 31A and the second counter portion 32A are opposed to each other with the dielectric layer 20 interposed therebetween, such that a capacitance is generated, and the characteristics of the capacitor are developed.

The shapes of each of the first counter portions 31A and each of the second counter portions 32A are not particularly limited, but are preferably rectangular. However, each of the corner portions of the rectangular shape may be rounded, or each of the corner portions of the rectangular shape may include an oblique portion. The shapes of each of the plurality of first extension portions 31B and each of the plurality of second extension portions 32B are not particularly limited, but are preferably rectangular. However, each of the corner portions of the rectangular shape may be rounded, or each of the corner portions of the rectangular shape may include an oblique portion.

The dimension of each of the plurality of first counter portions 31A in the width direction W and the dimension of each of the plurality of first extension portions 31B in the width direction W may be the same, or either one of them may be smaller. The dimension of each of the plurality of second counter portions 32A in the width direction W and the dimension of each of the plurality of second extension portions 32B in the width direction W may be the same, or either one of them may be narrower.

Each of the plurality of first internal electrode layers 31 and each of the plurality of second internal electrode layers 32 are made of an appropriate electrically conductive material such as a metal such as Ni, Cu, Ag, Pd, or Au, or an alloy containing at least one of these metals. When an alloy is used, each of the plurality of first internal electrode layers 31 and each of the plurality of second internal electrode layers 32 may be made of, for example, an Ag-Pd alloy.

Each of the thicknesses of the plurality of first internal electrode layers 31 and the plurality of second internal electrode layers 32 are preferably, for example, about 0.2 µm or more and 2.0 µm or less. The total number of the plurality of first internal electrode layers 31 and the plurality of second internal electrode layers 32 is preferably 10 or more and 700 or less.

The first main surface-side outer layer portion 12A is positioned adjacent to the first main surface TS1 of the multilayer body 10. The first main surface-side outer layer portion 12A is an aggregate of a plurality of dielectric layers 20 positioned between the first main surface TS1 and the internal electrode layer 30 closest to the first main surface TS1. The dielectric layers 20 in the first main surface-side outer layer portion 12A may be the same as the dielectric layers 20 in the inner layer portion 11, or may be dielectric layers made of a different material.

The second main surface-side outer layer portion 12B is positioned adjacent to the second main surface TS2 of the multilayer body 10. The second main surface-side outer layer portion 12B is an aggregate of a plurality of dielectric layers 20 positioned between the second main surface TS2 and the internal electrode layer 30 closest to the second main surface TS2. The dielectric layers 20 in the second main surface-side outer layer portion 12B may be the same as the dielectric layers 20 in the inner layer portion 11, or may be a dielectric layer made of a different material.

The multilayer body 10 includes a counter electrode portion 11E. The counter electrode portion 11E is a portion where the first counter portions 31A of the first internal electrode layers 31 and the second counter portions 32A of the second internal electrode layers 32 are opposed to each other. The counter electrode portion 11E is a portion of the inner layer portion 11. FIG. 4 shows the range in the width direction W and the length direction L of the counter electrode portion 11E. The counter electrode portion 11E is also referred to as a capacitor effective portion.

The multilayer body 10 includes lateral surface-side outer layer portions. The lateral surface-side outer layer portion includes a first lateral surface-side outer layer portion WG1 and a second lateral surface-side outer layer portion WG2. The first lateral surface-side outer layer portion WG1 is a portion including the dielectric layers 20 positioned between the counter electrode portion 11E and the first lateral surface WS1. The second lateral surface-side outer layer portion WG2 is a portion including the dielectric layers 20 positioned between the counter electrode portion 11E and the second lateral surface WS2. FIGS. 3 and 4 each show the ranges in the width direction W of the first lateral surface-side outer layer portion WG1 and the second lateral surface-side outer layer portion WG2. The lateral surface-side outer layer portions are also each referred to as a W gap or a side gap.

The multilayer body 10 includes end surface-side outer layer portions. The end surface-side outer layer portions include a first end surface-side outer layer portion LG1 and a second end surface-side outer layer portion LG2. The first end surface-side outer layer portion LG1 is a portion including the dielectric layers 20 positioned between the counter electrode portion 11E and the first end surface LS1. The second end surface-side outer layer portion LG2 is a portion including the dielectric layers 20 positioned between the counter electrode portion 11E and the second end surface LS2. FIGS. 2 and 4 each show a range in the length direction L of the first end surface-side outer layer portion LG1 and the second end surface-side outer layer portion LG2. The end surface-side outer layer portions are also each referred to as an L gap or an end gap.

The external electrodes 40 include a first external electrode 40A on and adjacent to the first end surface LS1 and a second external electrode 40B on and adjacent to the second end surface LS2.

The first external electrode 40A is provided on the first end surface LS1. The first external electrode 40A is connected to the first internal electrode layers 31. The first external electrode 40A may also be provided on a portion of the first main surface TS1 and a portion of the second main surface TS2, and also on a portion of the first lateral surface WS1 and a portion of the second lateral surface WS2. In the present embodiment, the first external electrode 40A extends from the first end surface LS1 to a portion of the first main surface TS1 and a portion of the second main surface TS2, and to a portion of the first lateral surface WS1 and a portion of the second lateral surface WS2.

The second external electrode 40B is provided on the second end surface LS2. The second external electrode 40B is connected to the second internal electrode layers 32. The second external electrode 40B may also be provided on a portion of the first main surface TS1 and a portion of the second main surface TS2, and also on a portion of the first lateral surface WS1 and a portion of the second lateral surface WS2. In the present embodiment, the second external electrode 40B extends from the second end surface LS2 to a portion of the first main surface TS1 and a portion of the second main surface TS2, and to a portion of the first lateral surface WS1 and a portion of the second lateral surface WS2.

As described above, in the multilayer body 10, the first counter portions 31A of the first internal electrode layers 31 and the second counter portions 32A of the second internal electrode layers 32 are opposed to each other with each of the dielectric layers 20 interposed therebetween, such that a capacitance is generated. Therefore, the characteristic of the capacitor is developed between the first external electrode 40A to which the first internal electrode layers 31 are connected and the second external electrode 40B to which the second internal electrode layers 32 are connected.

The first external electrode 40A includes a first base electrode layer 50A including a metal component, a first electrically conductive resin layer 60A provided on the first base electrode layer 50A, and a first plated layer 70A provided on the first electrically conductive resin layer 60A. The first plated layer 70A includes a first Ni plated layer 71A functioning as a lower plated layer and a first Sn plated layer 72A functioning as an upper plated layer.

The second external electrode 40B includes a second base electrode layer 50B including a metal component, a second electrically conductive resin layer 60B provided on the second base electrode layer 50B, and a second plated layer 70B provided on the second electrically conductive resin layer 60B. The second plated layer 70B include a second Ni plated layer 71B functioning as a lower plated layer and a second Sn plated layer 72B functioning as an upper plated layer.

As shown in FIGS. 2 and 4, the first Ni plated layer 71A includes a first end surface-side Ni plated layer 71A1 and a first lateral surface-side Ni plated layer 71A2. The first Ni plated layer 71A includes a first end portion which indicates a portion of the first Ni plated layer 71A that is closer to the second end surface LS2 than the first electrically conductive resin layer 60A in the length direction L.

As shown in FIGS. 2 and 4, the second Ni plated layer 71B includes a second end surface-side Ni plated layer 71B1 and a second lateral surface-side Ni plated layer 71B2. The second Ni plated layer 71B includes a second end portion which indicates a portion of the second Ni plated layer 71B that is closer to the first end surface LS1 than the second electrically conductive resin layer 60B in the length direction L.

Here, the basic configuration of the respective layers of the first external electrode 40A and the second external electrode 40B are the same. The first external electrode 40A and the second external electrode 40B are substantially plane symmetrical with respect to the LW cross section in the middle in the length direction L of the multilayer ceramic capacitor 1. Therefore, in a case where it is not necessary to particularly distinguish between the first external electrode 40A and the second external electrode 40B, the first external electrode 40A and the second external electrode 40B may be collectively referred to as an external electrode 40. In a case where there is no need to particularly distinguish between the first base electrode layer 50A and the second base electrode layer 50B, the first base electrode layer 50A and the second base electrode layer 50B may be collectively referred to as a base electrode layer 50. In a case where there is no need to particularly distinguish between the first electrically conductive resin layer 60A and the second electrically conductive resin layer 60B, the first electrically conductive resin layer 60A and the second electrically conductive resin layer 60B may be collectively referred to as an electrically conductive resin layer 60. In a case where it is not necessary to particularly distinguish between the first plated layer 70A and the second plated layer 70B, the first plated layer 70A and the second plated layer 70B may be collectively referred to as a plated layer 70. In a case where it is not necessary to particularly distinguish between the first Ni plated layer 71A and the second Ni plated layer 71B, the first Ni plated layer 71A and the second Ni plated layer 71B may be collectively referred to as a Ni plated layer 71. In a case where it is not necessary to particularly distinguish between the first Sn plated layer 72A and the second Sn plated layer 72B, the first Sn plated layer 72A and the second Sn plated layer 72B may be collectively referred to as the Sn plated layer 72. When it is not necessary to particularly distinguish between the first end surface-side Ni plated layer 71A1 and the second end surface-side Ni plated layer 71B1, the first end surface-side Ni plated layer 71A1 and the second end surface-side Ni plated layer 71B1 may be collectively referred to as an end surface-side Ni plated layer 711. When it is not necessary to particularly distinguish and describe the first lateral surface-side Ni plated layer 71A2 and the second lateral surface-side Ni plated layer 71B2, the first lateral surface-side Ni plated layer 71A2 and the second lateral surface-side Ni plated layer 71B2 may be collectively referred to as a lateral surface-side Ni plated layer 712. When it is not necessary to particularly distinguish between the first end surface LS1 and the second end surface LS2, the first end surface LS1 and the second end surface LS2 may be collectively referred to as an end surface LS.

The base electrode layer 50 includes a first base electrode layer 50A and a second base electrode layer 50B.

The first base electrode layer 50A is provided on the first end surface LS1. The first base electrode layer 50A is connected to the first internal electrode layers 31. Further, the first base electrode layer 50A may also be provided on a portion of the first main surface TS1, a portion of the second main surface TS2, a portion of the first lateral surface WS1, and a portion of the second lateral surface WS2. In the present embodiment, the first base electrode layer 50A extends from the first end surface LS1 to a portion of the first main surface TS1 and a portion of the second main surface TS2, and to a portion of the first lateral surface WS1 and a portion of the second lateral surface WS2.

The second base electrode layer 50B is provided on the second end surface LS2. The second base electrode layer 50B is connected to the second internal electrode layers 32. Further, the second base electrode layer 50B may also be provided on a portion of the first main surface TS1, a portion of the second main surface TS2, a portion of the first lateral surface WS1, and a portion of the second lateral surface WS2. In the present embodiment, the second base electrode layer 50B extends from the second end surface LS2 to a portion of the first main surface TS1 and a portion of the second main surface TS2, and to a portion of the first lateral surface WS1 and a portion of the second lateral surface WS2.

The first base electrode layer 50A and the second base electrode layer 50B of the present embodiment are fired layers. The fired layers each preferably contains a metal component and either or both of a glass component and a ceramic component. Thus, the adhesion between the multilayer body 10 and the base electrode layer 50 can be improved. The metal component includes, for example, at least one selected from Cu, Ni, Ag, Pd, Ag-Pd alloy, Au, and the like. The glass component includes, for example, at least one selected from B, Si, Ba, Mg, Al, Li, and the like. When a glass component is present, sintering of the metal component in the base electrode layer can be promoted and advanced. The ceramic component may be a ceramic material of the same kind as the dielectric layer 20 or a ceramic material of a different kind. The ceramic component includes, for example, at least one selected from BaTiO₃, CaTiO₃, (Ba, Ca)TiO₃, SrTiO₃, CaZrO₃, and the like.

The fired layer is formed, for example, by coating a multilayer body with an electrically conductive paste containing glass and metal and firing the resulting product. The fired layer may be obtained by simultaneously firing a multilayer chip having internal electrode layers and dielectric layers and an electrically conductive paste applied to the multilayer chip, or may be obtained by firing a multilayer chip having internal electrode layers and dielectric layers to obtain a multilayer body, and then firing the multilayer body by applying the electrically conductive paste to the multilayer body. In a case where the multilayer chip having the internal electrode layers and the dielectric layers, and the electrically conductive paste applied to the multilayer chip are simultaneously fired, the fired layer including a ceramic material instead of the glass component is preferably formed. In this case, it is particularly preferable to use the same kind of ceramic material as the dielectric layer 20 as the ceramic material to be added. The fired layer may include a plurality of layers.

The thickness in the length direction of the first base electrode layer 50A positioned at the first end surface LS1 is preferably, for example, about 2 µm or more and 220 µm or less in the middle of the first base electrode layer 50A in the lamination direction T and the width direction W.

The thickness in the length direction of the second base electrode layer 50B positioned at the second end surface LS2 is preferably, for example, about 2 µm or more and 220 µm or less in the middle of the second base electrode layer 50B in the lamination direction T and the width direction W.

In a case where the first base electrode layer 50A is provided also on a portion of at least one surface of the first main surface TS1 or the second main surface TS2, the thickness of the first base electrode layer 50A provided on this portion in the lamination direction is preferably, for example, about 4 µm or more and 40 µm or less in the middle in the length direction L and the width direction W of the first base electrode layer 50A provided on this portion.

In a case where the first base electrode layer 50A is provided also on a portion of at least one of the first lateral surface WS1 and the second lateral surface WS2, the thickness in the width direction of the first base electrode layer 50A provided on this portion is preferably, for example, about 4 µm or more and 40 µm or less in the middle in the length direction L and the lamination direction T of the first base electrode layer 50A provided on this portion.

In a case where the second base electrode layer 50B is provided on a portion of at least one surface of the first main surface TS1 or the second main surface TS2, the thickness of the second base electrode layer 50B provided on this portion in the lamination direction is preferably, for example, about 4 µm or more and 40 µm or less in the middle in the length direction L and the width direction W of the second base electrode layer 50B provided on this portion.

In a case where the second base electrode layer 50B is provided also on a portion of at least one of the first lateral surface WS1 and the second lateral surface WS2, the thickness in the width direction of the second base electrode layer 50B provided on this portion is preferably, for example, about 4 µm or more and 40 µm or less in the middle in the length direction L and the lamination direction T of the second base electrode layer 50B provided on this portion.

Each of the external electrodes 40 includes an electrically conductive resin layer 60 containing a resin component and a metal component provided on the base electrode layer 50. The electrically conductive resin layer 60 includes a first electrically conductive resin layer 60A and a second electrically conductive resin layer 60B.

The first electrically conductive resin layer 60A covers the first base electrode layer 50A. The first electrically conductive resin layer 60A includes an end portion which is preferably in contact with the multilayer body 10. The end portion of the first electrically conductive resin layer 60A indicates a portion of the first electrically conductive resin layer 60A closer to the second end surface LS2 than the first base electrode layer 50A in the length direction L. The second electrically conductive resin layer 60B covers the second base electrode layer 50B. The second electrically conductive resin layer 60B includes an end portion which is preferably in contact with the multilayer body 10. The end portion of the second electrically conductive resin layer 60B indicates a portion of the second electrically conductive resin layer 60B closer to the first end surface LS1 than the second base electrode layer 50B in the length direction L.

The thickness in the length direction of the first electrically conductive resin layer 60A positioned adjacent to the first end surface LS1 is preferably, for example, about 10 µm or more and 200 µm or less in the middle of the first electrically conductive resin layer 60A in the lamination direction T and the width direction W.

The thickness in the length direction of the second electrically conductive resin layer 60B positioned adjacent to the second end surface LS2 is preferably, for example, about 10 µm or more and 200 µm or less in the middle of the second electrically conductive resin layer 60B in the lamination direction T and the width direction W.

In a case where the first electrically conductive resin layer 60A is also provided on a portion of the first main surface TS1 and a portion of the second main surface TS2, the thickness in the lamination direction T of the first electrically conductive resin layer 60A provided on this portion is preferably, for example, about 10 µm or more and 200 µm or less in the middle of the first electrically conductive resin layer 60A provided on this portion in the length direction L and the width direction W.

In a case where the first electrically conductive resin layer 60A is also provided on a portion of the first lateral surface WS1 and a portion of the second lateral surface WS2, the thickness in the width direction W of the first electrically conductive resin layer 60A provided on this portion is preferably, for example, about 10 µm or more and 200 µm or less in the middle of the first electrically conductive resin layer 60A provided on this portion in the length direction L and the lamination direction T.

In a case where the second electrically conductive resin layer 60B is also provided on a portion of the first main surface TS1 and a portion of the second main surface TS2, the thickness of the second electrically conductive resin layer 60B provided on this portion in the lamination direction T is preferably, for example, about 10 µm or more and 200 µm or less in the middle of the second electrically conductive resin layer 60B provided on this portion in the length direction L and the width direction W.

In a case where the second electrically conductive resin layer 60B is also provided on a portion of the first lateral surface WS1 and a portion of the second lateral surface WS2, the thickness in the width direction W of the second electrically conductive resin layer 60B provided on this portion is preferably, for example, about 10 µm or more and 200 µm or less in the middle of the second electrically conductive resin layer 60B provided on this portion in the length direction L and the lamination direction T.

The electrically conductive resin layer 60 is provided on the base electrode layer 50. The plated layer 70 covers the electrically conductive resin layer 60. The plated layer 70 includes a Ni plated layer 71 and a Sn plated layer 72.

The electrically conductive resin layer 60 includes a resin portion and electrically conductive fillers dispersed in the resin portion.

The resin portion of the electrically conductive resin layer 60 may include, for example, at least one of various known thermosetting resins such as epoxy resin, phenoxy resin, phenol resin, urethane resin, silicone resin, and polyimide resin. Among them, epoxy resins excelling in heat resistance, moisture resistance, adhesiveness and the like are the most suitable resins. The resin portion of the electrically conductive resin layer 60 preferably contains a curing agent together with the thermosetting resin. When an epoxy resin is used as the base resin, the curing agent of the epoxy resin may be any of various known compounds such as phenolic, amine-based, acid anhydride-based, imidazole-based, active ester-based, and amideimide-based compounds.

Since the electrically conductive resin layer 60 includes such a resin portion, it is more flexible than, for example, the base electrode layer 50 made of a plated film or a fired product of a metal component and a glass component. Therefore, even when a physical impact or shock caused by thermal cycling is applied to the multilayer ceramic capacitor 1, the electrically conductive resin layer 60 functions as a buffer layer. Accordingly, it is possible for the electrically conductive resin layer 60 to reduce or prevent the generation of cracks in the multilayer ceramic capacitor 1.

The electrically conductive filler is dispersed in the resin portion in a substantially uniform distribution. The electrically conductive filler mainly maintains the conductivity of the electrically conductive resin layer 60. Specifically, when the plurality of electrically conductive fillers are brought into contact with each other, an electric current-carrying path is provided inside the electrically conductive resin layer 60, such that the base electrode layer 50 and the plated layer 70 are electrically connected to each other.

The metal of the electrically conductive filler may be Ag alone, an alloy containing Ag, or metal powder including Ag coating on the surface of the metal powder. Ag is suitable for electrode materials because of its lowest specific resistance among metals. Since Ag is a noble metal, it hardly oxidizes and the weatherability is high. Therefore, the metal powder of Ag is suitable as the electrically conductive filler. When a metal powder coated with Ag is used, Cu, Ni, Sn, Bi or an alloy powder containing them is preferably used as the metal powder.

Further, the electrically conductive filler may be formed by subjecting Cu and Ni to an oxidation preventing treatment. The electrically conductive filler may be a metal powder obtained by coating the surface of the metal powder with Sn, Ni, or Cu. When a metal powder coated with Sn, Ni, or Cu is used, the metal powder is preferably Ag, Cu, Ni, Sn, or Bi or an alloy powder thereof.

The shape of the electrically conductive filler is not particularly limited. The electrically conductive filler may have a spherical shape, a flat shape, or the like. Further, it is preferable to use a combination of metal powders having a spherical shape and a flat shape.

The average particle diameter of the conductive filler may be, for example, 0.3 µm or more and 10 µm or less.

The measurement method for the average particle diameter of the electrically conductive filler contained in the electrically conductive resin layer 60 calculates the average particle diameter by using a laser diffraction particle size measurement method based on ISO 13320 regardless of the shape of the electrically conductive filler.

The plated layer 70 includes the first plated layer 70A and the second plated layer 70B.

The first plated layer 70A covers the first electrically conductive resin layer 60A. In the present embodiment, the first plated layer 70A extends from the first end surface LS1 to a portion of the first main surface TS1 and a portion of the second main surface TS2, and to a portion of the first lateral surface WS1 and a portion of the second lateral surface WS2. More specifically, the first plated layer 70A is provided such that the first end surface-side Ni plated layer 71A1 described above is provided on the first end surface LS1, and the first lateral surface-side Ni plated layer 71A2 described above extends from the first end surface LS1 to a portion of the first main surface TS1 and a portion of the second main surface TS2, and to a portion of the first lateral surface WS1 and a portion of the second lateral surface WS2.

The second plated layer 70B covers the second electrically conductive resin layer 60B. In the present embodiment, the second plated layer 70B extends from the first end surface LS1 to a portion of the first main surface TS1 and a portion of the second main surface TS2, and to a portion of the first lateral surface WS1 and a portion of the second lateral surface WS2. More specifically, the second plated layer 70B is provided such that the second end surface-side Ni plated layer 71B1 described above is provided on the second end surface LS2, and the second lateral surface-side Ni plated layer 71B2 described above extends from the second end surface LS2 to a portion of the first main surface TS1 and a portion of the second main surface TS2, and to a portion of the first lateral surface WS1 and a portion of the second lateral surface WS2.

The plated layer 70 preferably has a two-layer structure of a Ni plated layer 71 and a Sn plated layer 72. The first Sn plated layer 72A is preferably provided on the first Ni plated layer 71A, and the second Sn plated layer 72B is preferably provided on the second Ni plated layer 71B. The Ni plated layer 71 prevents the base electrode layer 50 and the electrically conductive resin layer 60 from being eroded by solder when the multilayer ceramic capacitor 1 is mounted. The Sn plated layer 72 improves wettability of solder when mounting the multilayer ceramic capacitor 1. This facilitates mounting of the multilayer ceramic capacitor 1.

The thicknesses of the first Ni plated layer 71A and the first Sn plated layer 72A are preferably 1 µm or more and 15 µm or less.

The thicknesses of the second Ni plated layer 71B and the second Sn plated layer 72B are preferably 1 µm or more and 15 µm or less.

FIG. 5 is an enlarged view of a portion V of the multilayer ceramic capacitor 1 shown in FIG. 2, and is a schematic view for explaining a state of the force generated in the vicinity of the end surface LS of the multilayer ceramic capacitor 1. As described above, since the first Ni plated layer 71A and the second Ni plated layer 71B have the same basic configuration, they will be collectively described as the Ni plated layer 71 with reference to FIG. 5. The same applies to other layers constituting the first external electrode 40A and the second external electrode 40B. As shown in FIG. 5, the electrically conductive resin layer 60 is provided on the base electrode layer 50. The plated layer 70 described later covers the electrically conductive resin layer 60. The plated layer 70 includes the Ni plated layer 71 and the Sn plated layer 72. The Ni plated layer 71 includes the end surface-side Ni plated layer 711 and the lateral surface-side Ni plated layer 712.

The Ni plated layer 71 is provided so that a tensile stress is uniformly generated as a whole in a direction intersecting the thickness direction of the plated layer 70. In other words, tensile stress remains as internal stress inside the Ni plated layer 71. In the end surface-side Ni plated layer 711, a tensile stress is generated in a direction intersecting the thickness direction of the plated layer 70, and the end surface-side Ni plated layer 711 tends to shrink in a direction intersecting the thickness direction of the plated layer 70. As shown in FIG. 5, the lateral surface-side Ni plated layers 712 are provided on both end sides of the end surface-side Ni plated layer 711 and sandwich the end surface-side Ni plated layer 711. Each of the lateral surface-side Ni plated layers 712 is pulled toward the middle of the end surface-side Ni plated layer 711. That is, the lateral surface-side Ni plated layers 712 provided on both sides of the end surface-side Ni plated layer 711 each receive a force in a direction in which the electrically conductive resin layer 60 is pressed against the base electrode layer 50. Such a configuration achieves the advantageous effects in that the electrically conductive resin layer 60 has improved conductivity and Equivalent Series Resistance (ESR) is reduced.

Further, the lateral surface-side Ni plated layers 712 tend to shrink in the direction intersecting the thickness direction of the plated layer 70 due to the generation of tensile stress in the direction intersecting the thickness direction of the plated layer 70 in the lateral surface-side Ni plated layers 712. Therefore, in a state where the lateral surface-side Ni plated layers 712 are fastened to the electrically conductive resin layer 60 in the circumferential direction of the lateral surface-side Ni plated layers 712, the end surface-side Ni plated layer 711 is pulled in the length direction L to press the electrically conductive resin layer 60 against the base electrode layer 50. With such a configuration, it is possible to improve the conductivity of the electrically conductive resin layer 60, and it is possible to reduce the ESR.

The tensile stress is preferably 50 MPa or more. With such a configuration, it is possible to further enhance the ESR reduction effect.

When the stress of the Ni plated layer 71 becomes larger than 206 MPa, it becomes difficult to manufacture the multilayer ceramic capacitor 1 in manufacturing, and thus the tensile stress is preferably 206 MPa or less. With such a configuration, it is possible to easily manufacture the multilayer ceramic capacitor 1, while further enhancing the ESR reduction effect.

When the dimension in the length direction of the multilayer ceramic capacitor 1 including the multilayer body 10 and the external electrode 40 is defined as an L dimension, the L dimension is preferably 0.2 mm or more and 10 mm or less. When the dimension of the multilayer ceramic capacitor 1 in the lamination direction is defined as a T dimension, the T dimension is preferably 0.1 mm or more and 10 mm or less. The dimension of the multilayer ceramic capacitor 1 in the width direction is defined as a W dimension. The W dimension is preferably 0.1 mm or more and 10 mm or less.

Next, a method of manufacturing the multilayer ceramic capacitor 1 of the present embodiment will be described.

A dielectric sheet for forming the dielectric layer 20 and an electrically conductive paste for forming the internal electrode layer 30 are prepared. The dielectric sheet and the electrically conductive paste for forming the internal electrodes include a binder and a solvent. The binder and the solvent may be well known.

The electrically conductive paste for forming the internal electrode layer 30 is printed on the dielectric sheet in a predetermined pattern by, for example, screen printing or gravure printing. Thus, a dielectric sheet having a pattern of the first internal electrode layer 31 and a dielectric sheet having a pattern of the second internal electrode layer 32 are prepared.

By laminating a predetermined number of dielectric sheets on which patterns of internal electrode layers are not printed, a portion functioning as the first main surface-side outer layer portion 12A adjacent to the first main surface TS1 is formed. A dielectric sheet on which the pattern of the first internal electrode layer 31 is printed and a dielectric sheet on which the pattern of the second internal electrode layer 32 is printed are sequentially laminated thereon, such that a portion functioning as the inner layer portion 11 is formed. A predetermined number of dielectric sheets on which patterns of internal electrode layers are not printed are laminated on a portion functioning as the inner layer portion 11, such that a portion functioning as the second main surface-side outer layer portion 12B adjacent to the second main surface TS2 is formed. Thus, a multilayer sheet is manufactured.

The multilayer sheet is pressed in the lamination direction by means of a hydrostatic press or the like to form a multilayer block.

By cutting the multilayer block into a predetermined size, the multilayer chip is cut out. At this time, the corner portions and ridge portions of the multilayer chip may be rounded by barrel polishing or the like.

The multilayer chip is fired to form the multilayer body 10. The firing temperature depends on the materials of the dielectric layer 20 and the internal electrode layer 30, but is preferably 900°C or higher and 1400°C or lower.

An electrically conductive paste functioning as the base electrode layer 50 is applied to both end surfaces of the multilayer body 10. In the present embodiment, the base electrode layer 50 is a fired layer. An electrically conductive paste containing a glass component and a metal is applied to the multilayer body 10 by a method such as dipping. Then, firing treatment is performed to form the base electrode layer 50. The temperature of the firing treatment at this time is preferably 700°C or higher and 950°C or lower.

Next, the electrically conductive resin layer 60 is formed. The electrically conductive resin layer 60 may be formed on the surface of the base electrode layer 50 or may be formed directly on the multilayer body 10. In the present embodiment, the electrically conductive resin layer 60 is formed on the surface of the base electrode layer 50.

First, an electrically conductive resin paste in which an electrically conductive filler is dispersed in a thermosetting resin as a base resin functioning as a resin portion is prepared. The electrically conductive resin paste is produced by stirring and mixing the thermosetting resin and the electrically conductive filler. Accordingly, the electrically conductive filler is dispersed and present in a uniform distribution in the electrically conductive resin paste. Here, the thermosetting resin is, for example, an epoxy resin. The electrically conductive filler is, for example, Ag metal powder.

Thereafter, the electrically conductive resin paste is applied onto the base electrode layer 50 using a dipping method, and heat treatment is performed at a temperature of 200°C or higher and 550°C or lower. Thus, the resin portion is thermally cured to form the electrically conductive resin layer 60. At this time, the atmosphere during the heat treatment is preferably an N₂ atmosphere. Further, in order to prevent scattering of the resin and oxidation of various metal components, the oxygen concentration is preferably curbed to 100 ppm or less.

Thereafter, the plated layer 70 is formed on the surface of the electrically conductive resin layer 60. In the present embodiment, the Ni plated layer 71 and the Sn plated layer 72 are formed on the electrically conductive resin layer 60. The Ni plated layer 71 and the Sn plated layer 72 are sequentially formed by electroplating. As a plating method, for example, barrel plating is preferably used.

The stress generated in the entire first Ni plated layer 71A and the entire second Ni plated layer 71B of the present invention can be controlled by the following method.

It is known that the stress generated in plating varies depending on the electric current density applied during film formation. The electric current density is randomly applied to the multilayer ceramic capacitor 1. In the tip portion of the Ni plated layer located on the first main surface TS1, the second main surface TS2, the first lateral surface WS1, or the second lateral surface WS2, the average electric current density applied to each tip portion from the initial stage of film formation of Ni plating until when the thickness becomes, for example, 3 µm is the same on any surface of the tip portion of the Ni plated layer located on the first main surface TS1, the second main surface TS2, the first lateral surface WS1, or the second lateral surface WS2. Therefore, the same stress is applied to any surface of the Ni plated layer 70 on the first main surface TS1, the second main surface TS2, the first lateral surface WS1, and the second lateral surface WS2.

The first Ni plated layer 71A and the second Ni plated layer 71B can be formed, for example, by conducting a plating bath using a plating solution prepared by adjusting the amounts of Ni sulfate and Ni sulfamate. It is possible to adjust the value of the residual stress inside the Ni plated layer 71 formed by adjusting the ratio of Ni sulfate and Ni sulfamate in the plating solution.

In the present embodiment, the Sn plated layer 72 is further formed on the Ni plated layer 71, the first Sn plated layer 72A is formed on the first Ni plated layer 71A, and the second Sn plated layer 72B is formed on the second Ni plated layer 71B. Electrolytic plating is used as a method of forming the Sn plated layer 72. Barrel plating is preferably used as a plating method. Thus, when the multilayer ceramic capacitor 1 is mounted, the wettability of the solder used for mounting can be improved, and mounting can be easily performed. The multilayer ceramic capacitor 1 is manufactured by the manufacturing method described above.

According to the multilayer ceramic capacitor 1 of the present embodiment, the following advantageous effects can be obtained.

In recent years, ceramic electronic components such as multilayer ceramic capacitors have been used in a more severe environment. For example, electronic components used in mobile devices such as mobile phones and portable music players are required to withstand impacts when dropped. Specifically, it is necessary to prevent the electronic component from falling off from the mounting board or to prevent cracks from occurring in the electronic component even when a drop impact is received.

Electronic components for use in vehicle-mounted equipment such as an Electronic Control Unit (ECU) are required to withstand thermal cycling shock. Specifically, it is necessary to prevent cracks from occurring in the electronic component even when a bending stress generated by thermal expansion and contraction of the mounting board due to thermal cycling is received.

In this regard, it has been proposed to use a thermosetting electrically conductive resin paste for the external electrode of the ceramic electronic component as a countermeasure against the occurrence of cracks in the ceramic electronic component body even under a severe environment. For example, an epoxy-based thermosetting resin layer is provided between the conventional electrode layer and the Ni plated layer.

In such a configuration, when a stress due to an impact at the time of dropping or a bending stress generated by thermal expansion and contraction of the mounting substrate due to thermal cycling occurs, the stress transmitted to the mounting substrate due to the distortion of the mounting substrate is relieved by the epoxy-based thermosetting resin layer, and cracking of the ceramic electronic component main body is reduced or prevented.

However, in the multilayer ceramic electronic component disclosed in Japanese Unexamined Patent Application Publication No. H11-162771, for example, the stress in the Ni plated layer provided on the electrically conductive resin layer is not specified.

In the present invention, since the tensile stress remains in the Ni plated layer, the Ni plated layer presses the electrically conductive resin layer toward the base electrode layer so that the electrically conductive resin layer is compressed, then the contact amount between the electrically conductive fillers in the electrically conductive resin layer increases, such that it is possible to improve the conductivity of the electrically conductive resin layer. Therefore, it is possible to provide multilayer ceramic electronic components that are each able to reduce ESR and each include improved initial characteristics.

(1) The multilayer ceramic capacitor 1 (the multilayer ceramic electronic component 1) according to the embodiment includes: the multilayer body 10 including the plurality of laminated dielectric layers 20 (the ceramic layers 20), the first main surface TS1 and the second main surface TS2 opposed to each other in the height direction T, the first lateral surface WS1 and the second lateral surface WS2 opposed to each other in the width direction W orthogonal or substantially orthogonal to the height direction T, and the first end surface LS1 and the second end surface LS2 opposed to each other in the length direction L orthogonal or substantially orthogonal to the height direction T and the width direction W; the first internal electrode layers 31 (the first internal conductive layers 31) that are each on a corresponding one of the plurality of dielectric layers 20 and are each exposed at the first end surface LS1; the second internal electrode layers 32 (the second internal conductive layers 32) that are each on a corresponding one of the plurality of dielectric layers 20 and are each exposed at the second end surface LS2; the first external electrode 40A on the first end surface LS1; and the second external electrode 40B on the second end surface LS2. The first external electrode 40A includes the first base electrode layer 50A including a metal component, the first electrically conductive resin layer 60A that is provided on the first base electrode layer 50A and includes a thermosetting resin and a metal component, and the first Ni plated layer 71A provided on the first electrically conductive resin layer 60A. The second external electrode 40B includes the second base electrode layer 50B including a metal component, the second electrically conductive resin layer 60B that is provided on the second base electrode layer 50B and includes a thermosetting resin and a metal component, and the second Ni plated layer 71B provided on the second electrically conductive resin layer 60B. Tensile stress remains as internal stress inside the first Ni plated layer 71A. Tensile stress remains as internal stress inside the second Ni plated layer 71B.

With such a configuration, it is possible to provide multilayer ceramic electronic components that are each able to reduce ESR.

(2) In the multilayer ceramic capacitor 1 according to the present embodiment, the tensile stress generated in each of the first Ni plated layer 71A and the second Ni plated layer 71B is 50 MPa or more.

With such a configuration, it is possible to reduce ESR.

(3) The multilayer ceramic capacitor 1 according to the present embodiment includes the first Sn plated layer 72A on the first Ni plated layer 71A and the second Sn plated layer 72B on the second Ni plated layer 71B.

With such a configuration, it is possible to reduce ESR while improving solder wettability.

(4) In the multilayer ceramic capacitor 1 according to the present embodiment, the first base electrode layer 50A includes a glass component or a ceramic component, and the second base electrode layer 50B includes a glass component or a ceramic component.

With such a configuration, it is possible to reduce ESR while improving the adhesion between the multilayer body and the base electrode layer.

### Examples

Multilayer ceramic capacitors each having the structures of FIGS. 1 to 4 were manufactured as samples of Examples and Comparative Examples by using the manufacturing method according to the above embodiment. With respect to the samples, the stress of the Ni plated layer was controlled by the method described in the above manufacturing method so that the stress described in Table 1 was obtained, and twenty-two samples were prepared for each stress condition. The specifications of each of the multilayer ceramic capacitors are as follows.
- Dimensions of a multilayer ceramic capacitor: 3.2 mm (length direction L) × 2.5 mm (width direction W) × 2.5 mm (lamination direction T)
- Ceramic Material: BaTiO₃
- Capacitance: 0.01 µF
- Rated Voltage: 50 V
- Structure of external electrode

(1) Base electrode layer: electrode containing electrically conductive metal (Cu) and glass component
Thickness of the base electrode layer in the middle portion in the height direction of the base electrode layer located on each of the first end surface and the second end surface: 15 µm
Thickness of the base electrode layer in the middle portion in the length direction of the base electrode layer located on each of the first main surface, the second main surface, the first lateral surface, and the second lateral surface: 4 µm (2) Electrically conductive resin layer
Electrically conductive resin layer portion: electrically conductive filler: Ag
Resin: epoxy based resin
Thermal curing temperature: 200°C
Thickness of the first electrically conductive resin layer portion located on each of the first end surface and the second end surface in the middle portion in the height direction: 20 µm
Thickness of the base electrode layer in the middle portion in the length direction of the base electrode layer located on each of the first main surface, the second main surface, the first lateral surface, and the second lateral surface: 20 µm (3) Ni plated layer
Thickness of Ni plated layer: thickness of the Ni plated layer in the middle portion in the height direction of the Ni plated layer located on each of the first end surface and the second end surface: 2 µm
Thickness of the Ni plated layer in the middle portion in the length direction of the Ni plated layer located on each of the first main surface, the second main surface, the first lateral surface, and the second lateral surface: 2.0 µm (4) Sn plated layer
Thickness of Sn plated layer: thickness of the Sn plated layer in the middle portion in the height direction of the Sn plated layer located on each of the first end surface and the second end surface: 1.5 µm
Thickness of the Sn plated layer in the middle portion in the length direction of the Sn plated layer located on each of the first main surface, the second main surface, the first lateral surface, and the second lateral surface: 1.0 µm

Next, the samples of Examples and Comparative Examples were subjected to stress measurement of Ni plating and ESR measurement. Stress measurement of Ni plating and ESR measurement were performed using different multilayer ceramic capacitors among multilayer ceramic capacitors manufactured in the same lot. In the stress measurement of the Ni plated layer, an average value of data of n = 2 was used as a measurement result. In the ESR of each of Examples and Comparative Examples, an average value of data of n = 20 at a measurement frequency of 1 MHz was used as a measurement result. Then, as determination criteria, a numerical value for ESR of 8 mΩ or less was determined to be "O" (circle symbol), a numerical value for ESR of 10 mΩ or less was determined to be "Δ" (triangle symbol), and a numerical value for ESR of more than 10 mΩ was determined to be "x" (cross symbol).

**[Table 1]**

| | Stress of Ni plated layer [Mpa] | ESR of chip [mΩ] | Determination |
|---|---|---|---|
| Comparative Example 1 | -9 | 12.7 | × |
| Example 1 | 10 | 10.0 | Δ |
| Example 2 | 35 | 9.8 | Δ |
| Example 3 | 50 | 7.1 | ○ |
| Example 4 | 66 | 6.6 | ○ |
| Example 5 | 113 | 6.2 | ○ |
| Example 6 | 113 | 5.2 | ○ |
| Example 7 | 120 | 4.0 | ○ |
| Example 8 | 160 | 4.8 | ○ |
| Example 9 | 173 | 5.1 | ○ |
| Example 10 | 206 | 5.0 | ○ |

### Stress Measurement of Ni plating

Hereinafter, the stress measurement of the Ni plating in the Examples will be described. The stress of the Ni plated layer was measured by the following method.

First, the multilayer ceramic capacitor 1 was immersed in a metal stripper solution (available from Melstrip (registered trademark) HN980M Meltex Co., Ltd.) for 5 minutes, and then rinsed with water to strip the Sn plated layer. With respect to each of the Ni plated layers adjacent to the first end surface LS1 and the second end surface LS2 of the multilayer ceramic capacitor 1, measurement was performed using an X-ray diffraction method (µ-XRD (X-ray Diffraction)) in a range of φ100 µm substantially in the middle of each of the surfaces of the Ni plated layers located on the first main surface TS1, the second main surface TS2, the first lateral surface WS1, and the second lateral surface WS2.

More specifically, the stress of the Ni plated layer on the first main surface TS1 was measured at the middle portion in both the length direction L and the width direction W of each of the first Ni plated layer 71A and the second Ni plated layer 71B on the first main surface TS1. The stress of the Ni plated layer on the second main surface TS2 was measured at the middle portion in both the length direction L and the width direction W of each of the first Ni plated layer 71A and the second Ni plated layer 71B on the second main surface TS2. The stress of the Ni plated layer on the first lateral surface WS1 was measured at the middle portion in both the length direction L and the lamination direction T of each of the first Ni plated layer 71A and the second Ni plated layer 71B on the first lateral surface WS1. The stress of the Ni plated layer on the second lateral surface WS2 was measured at the middle portion in both the length direction L and the lamination direction T of each of the first Ni plated layer 71A and the second Ni plated layer 71B on the second lateral surface WS2. The two prepared samples were measured, and an average value of the above eight measurement values was used as a measurement value of stress.

Measurement of ESR of Multilayer Ceramic Capacitor The measurement of ESR in the Examples will be described below. Regarding the measurement of ESR of the multilayer ceramic capacitor **1,** the multilayer ceramic capacitor 1 was subjected to heat treatment in an air atmosphere at 150°C for 1 hour before the measurement, then mounted on a measurement substrate, and measured at a measurement frequency of 1 MHz after 24 ± 2 hours from the completion of the heat treatment using a network analyzer. The prepared twenty samples were measured, and the average value was defined as the value in Table 1 above.

From the above results, it was shown that in the present invention, by setting the stress of the Ni plated layer provided on the electrically conductive resin layer to the tensile stress, the Ni plating presses the electrically conductive resin layer toward the base electrode layer, the electrically conductive resin layer is compressed, and the contact amount between the electrically conductive fillers in the electrically conductive resin layer increases, such that the conductivity of the electrically conductive resin layer is improved.

Further, by setting the stress of the Ni plated layer to 50 MPa or more, the advantageous effect of the present invention can be made more remarkable, and a multilayer ceramic capacitor having improved initial characteristics can be provided.

The configuration of the multilayer ceramic capacitor 1 is not limited to the configurations shown in FIGS. 1 to 4. For example, the multilayer ceramic capacitor 1 may be a multilayer ceramic capacitor including a two-portion structure, a three-portion structure, or a four-portion structure as shown in FIGS. 6, 7, and 8.

The multilayer ceramic capacitor 1 shown in FIG. 6 is a multilayer ceramic capacitor 1 having a two-portion structure, and includes, as internal electrode layers 30, floating internal electrode layers 35 which are not exposed at either the first end surface LS1 or the second end surface LS2 in addition to the first internal electrode layers 33 and the second internal electrode layers 34. The multilayer ceramic capacitor 1 shown in FIG. 7 is a multilayer ceramic capacitor 1 having a three-portion structure including first floating internal electrode layers 35A and second floating internal electrode layers 35B as floating internal electrode layers 35. The multilayer ceramic capacitor 1 shown in FIG. 8 is a multilayer ceramic capacitor 1 having a four-portion structure including first floating internal electrode layers 35A, second floating internal electrode layers 35B, and third floating internal electrode layers 35C as floating internal electrode layers 35. As described above, by providing the floating internal electrode layers 35 as the internal electrode layers 30, the multilayer ceramic capacitor 1 has a structure in which the counter electrode portions are divided into a plurality of portions. With such a configuration, a plurality of capacitor components are provided between the opposing internal electrode layers 30, and these capacitor components are connected in series. Therefore, the voltages applied to the respective capacitor components are reduced, and thus it is possible to improve the pressure resistance of the multilayer ceramic capacitor 1. In addition, the multilayer ceramic capacitor 1 of the present embodiment may include a multiple-portion structure of four or more.

The multilayer ceramic capacitor 1 may be of a two-terminal type including two external electrodes or of a multi-terminal type including a large number of external electrodes.

In the above-described embodiments, as the multilayer ceramic electronic component, a multilayer ceramic capacitor in which the dielectric layers 20 made of dielectric ceramic are used as a ceramic layer is exemplified. However, the multilayer ceramic electronic component of the present disclosure is not limited thereto. For example, the ceramic electronic component of the present disclosure can be applied to various multilayer ceramic electronic components such as a piezoelectric component using a piezoelectric ceramic as a ceramic layer, a thermistor using a semiconductor ceramic as a ceramic layer, and an inductor using a magnetic ceramic as a ceramic layer. Piezoelectric ceramic includes PZT (lead zirconate titanate) ceramic, semiconductor ceramic includes spinel ceramic, and magnetic ceramic includes ferrite ceramic.

The present invention is not limited to embodiments of the present invention, and can be appropriately modified and applied without departing from the gist of the present invention. The present invention also includes combinations of two or more of the individual desirable configurations described in the above embodiments.

<1> A multilayer ceramic electronic component includes: a multilayer body including a plurality of laminated ceramic layers, a first main surface and a second main surface opposed to each other in a height direction, a first lateral surface and a second lateral surface opposed to each other in a width direction orthogonal or substantially orthogonal to the height direction, and a first end surface and a second end surface opposed to each other in a length direction orthogonal or substantially orthogonal to the height direction and the width direction; first internal conductive layers that are each on a corresponding one of the plurality of ceramic layers and are each exposed at the first end surface; second internal conductive layers that are each on a corresponding one of the plurality of ceramic layers and are each exposed at the second end surface; a first external electrode on the first end surface; and a second external electrode on the second end surface, in which the first external electrode includes a first base electrode layer including a metal component, a first electrically conductive resin layer that is provided on the first base electrode layer and includes a thermosetting resin and a metal component, and a first Ni plated layer provided on the first electrically conductive resin layer; the second external electrode includes a second base electrode layer including a metal component, a second electrically conductive resin layer that is provided on the second base electrode layer and includes a thermosetting resin and a metal component, and a second Ni plated layer provided on the second electrically conductive resin layer; tensile stress remains as internal stress inside the first Ni plated layer; and tensile stress remains as internal stress inside the second Ni plated layer.
<2> In the multilayer ceramic electronic component according to <1> above, the tensile stress is 50 MPa or more.
<3> In the multilayer ceramic electronic component according to <1> or <2> above, a first Sn plated layer is on the first Ni plated layer, and a second Sn plated layer is on the second Ni plated layer.
<4> In the multilayer ceramic electronic component according to any one of <1> to <3> above, the first base electrode layer includes a glass component or a ceramic component, and the second base electrode layer includes a glass component or a ceramic component.

### EXPLANATION OF REFERENCE NUMERALS

1 multilayer ceramic capacitor (multilayer ceramic electronic component)
10 multilayer body
20 dielectric layer (ceramic layer)
31 first internal electrode layer (first internal conductive layer)
32 second internal electrode layer (second internal conductive layer)
40A first external electrode
40B second external electrode
50A first base electrode layer
50B second base electrode layer
60A first electrically conductive resin layer
60B second electrically conductive resin layer
71A first Ni plated layer
71B second Ni Plated Layer
T height direction
TS1 first main surface
TS2 second main surface
W width direction
WS1 first lateral surface
WS2 second lateral surface
L length direction
LS1 first end surface
LS2 second end surface

## Claims

1. A multilayer ceramic electronic component comprising:
a multilayer body including a plurality of laminated ceramic layers, a first main surface and a second main surface opposed to each other in a height direction, a first lateral surface and a second lateral surface opposed to each other in a width direction orthogonal or substantially orthogonal to the height direction, and a first end surface and a second end surface opposed to each other in a length direction orthogonal or substantially orthogonal to the height direction and the width direction;
first internal conductive layers that are each on a corresponding one of the plurality of ceramic layers and are each exposed at the first end surface;
second internal conductive layers that are each on a corresponding one of the plurality of ceramic layers and are each exposed at the second end surface;
a first external electrode on the first end surface; and
a second external electrode on the second end surface,
wherein
the first external electrode includes a first base electrode layer including a metal component, a first electrically conductive resin layer that is provided on the first base electrode layer and includes a thermosetting resin and a metal component, and a first Ni plated layer provided on the first electrically conductive resin layer;
the second external electrode includes a second base electrode layer including a metal component, a second electrically conductive resin layer that is provided on the second base electrode layer and includes a thermosetting resin and a metal component, and a second Ni plated layer provided on the second electrically conductive resin layer;
tensile stress remains as internal stress inside the first Ni plated layer; and
tensile stress remains as internal stress inside the second Ni plated layer.

2. The multilayer ceramic electronic component according to claim 1, wherein the tensile stress is 50 MPa or more.

3. The multilayer ceramic electronic component according to claim 1 or 2, wherein
a first Sn plated layer is on the first Ni plated layer, and
a second Sn plated layer is on the second Ni plated layer.

4. The multilayer ceramic electronic component according to any one of claims 1 to 3, wherein
the first base electrode layer includes a glass component or a ceramic component, and
the second base electrode layer includes a glass component or a ceramic component.
